# EUROPEAN PATENT APPLICATION

(11) **EP 1 513 382 A2**
(43) Date of publication of application: **09.03.2005**
(21) Application number: 04021212.8
(22) Date of filing: 07.09.2004
(51) Int. Cl.: H05K 3/38, H05K 3/42

(54) **Conductive sheet having conductive layer with improved adhesion and product including the same**

(30) Priority: 08.09.2003 JP 2003315131
(71) Applicant: FCM Co., Ltd., Osaka-shi, Osaka (JP)
(72) Inventor: Miura, Shigeki, Osaka-shi Osaka (JP)
(74) Representative: Grünecker, Kinkeldey, Stockmair & Schwanhäusser Anwaltssozietät

(57) **Abstract**

A conductive sheet (1) according to the present invention includes: an insulating substrate (2) having at least one via hole (3), a ground conductive layer (5); and a top conductive layer (6), and characterized in that the via hole (3) is a fine pore penetrating through the insulating substrate (2), the ground conductive layer (5) is formed by a sputtering method or a vapor deposition method on all of a surface of the insulating substrate (2), the top conductive layer (6) is formed on all of or part of a surface of the ground conductive layer (5), and the via hole (3) is filled with the top conductive layer (6).

## Description

This nonprovisional application is based on Japanese Patent Application No. 2003-315131 filed with the Japan Patent Office on September 8, 2003, the entire contents of which are hereby incorporated by reference.

### BACKGROUND OF THE INVENTION

### Field of the Invention

The present invention relates to a conductive sheet. More particularly, the present invention relates to a conductive sheet that is useful as various circuit boards, and to a conductive sheet that can be used for various products (for example, an electric product, an electronic product, a semiconductor product, an antenna circuit board, an IC card, a solar battery or an automobile).

### Description of the Background Art

As an FPC (Flexible Printed Circuit) or a TAB (Tape Automated Bonding) board used as a circuit board for electric/electronic component or a circuit board for a semiconductor, for example as disclosed in Japanese Patent Laying Open No. 9-148698, a conductive sheet of a structure in which a copper foil to be a conductive layer is bonded to an insulating substrate has been used.

As for the conductive sheet of such a structure, it is necessary to adhere the insulating substrate and the copper foil to each other with high adhesion, in order to improve workability in forming circuitry, or to avoid electric disconnection or short-circuiting of the formed circuitry. The methods having been employed for attaining such adhesion include, for example, application of an adhesive to an insulating substrate so that the insulating substrate and a copper foil can be bonded to each other, and casting of a resin on a copper foil. In order to further improve the adhesion between the insulating substrate and the copper foil, attempts such as selecting various adhesives and adhering copper grains on the copper foil surface so as to form uneven protrusions have been made.

Though these methods can attain adhesion between the insulating substrate and the copper foil to some extent, each of these methods has been found to be involved with the following problems as circuitry patterns have been formed increasingly finer. Specifically, if an adhesive is used, the thickness of the applied adhesive amounts to 10-30 µm irrespective of the type of the adhesive, whereby the overall thickness of the conductive sheet is increased, which is a disadvantageous factor for the finer formation of the circuitry pattern. Further, when the conductive layer is etched to obtain a finely formed circuitry pattern, this layer of the adhesive may hinder the etching. Still further, if the copper grains are to be adhered on the copper foil surface to form uneven protrusions, the grains may hinder the finer formation of the circuitry pattern. Still further, such problems are aggravated when a copper foil is bonded to each of the front and back surfaces of the insulating substrate.

Accordingly, various methods for directly forming the conductive layer on the insulating substrate have been contemplated in order not to bond the copper foil and the insulating substrate to each other through an adhesive or uneven protrusions as described above. As a conductive sheet obtained by such a method, for example as disclosed in Japanese Patent Laying-Open No. 2002-43752, a conductive sheet is proposed in which a conductive layer is formed on an insulating substrate by electroless plating, and further another conductive layer is formed thereon by electroplating.

In the conductive sheet with the conductive layers formed by such a method, however, the adhesion between the conductive layer by electroless plating and the insulating substrate is low, and therefore a conductive sheet with further improved adhesion between them has been required.

Japanese Patent Laying-Open Nos. 2003-133669 and 11-214838 each disclose a circuit substrate in which a ground layer is formed on a substrate by sputtering or the like, and a conductive layer is formed thereon by plating. They are, however, silent about the solution for deterioration of the ground layer, and thus they are involved with a problem that adhesion of the conductive layer is reduced due to the deterioration of the ground layer.

### SUMMARY OF THE INVENTION

The present invention is made in light of the state of the art described above, and an object thereof is to provide a conductive sheet in which adhesion between an insulating substrate and a conductive layer is improved.

A conductive sheet according to the present invention includes: an insulating substrate having at least one via hole; a ground conductive layer; and a top conductive layer, and characterized in that the via hole is a fine pore penetrating through the insulating substrate, the ground conductive layer is formed by a sputtering method or a vapor deposition method on all of a surface of the insulating substrate including a wall surface of the via hole, the top conductive layer is formed on all of or part of a surface of the ground conductive layer, and the via hole is filled with the top conductive layer.

Further, a conductive sheet according to the present invention includes: an insulating substrate having at least one via hole; a metal foil; a ground conductive layer; and a top conductive layer, and characterized in that the metal foil is bonded to one surface of the insulating substrate, the via hole is a fine pore penetrating only through the insulating substrate, the ground conductive layer is formed by a sputtering method or a vapor deposition method on a wall surface of the via hole and on a surface of the insulating substrate to which the metal foil is not bonded, the top conductive layer is formed on all of or part of a surface of the ground conductive layer, and the via hole is filled with the top conductive layer.

Preferably, the insulating substrate is irradiated with ions by an ion gun. Preferably, the via hole is open by substantially the same area in both front and back surfaces of the insulating substrate.

Preferably, the top conductive layer is formed by an electroplating method and the via hole is filled with the top conductive layer concurrently with formation of the top conductive layer.

Preferably, the ground conductive layer or the top conductive layer is processed so as to form circuitry. Preferably, the metal foil is also processed so as to form circuitry.

Preferably, the ground conductive layer and the top conductive layer are constituted by Cu or an alloy containing Cu, and the metal foil is a copper foil.

Preferably, a deterioration preventing layer is formed by the sputtering method or the vapor deposition method between all of a surface of the insulating substrate including a wall surface of the via hole and the ground conductive layer. Preferably, the deterioration preventing layer is formed by the sputtering method or the vapor deposition method between a wall surface of the via hole as well as a surface of the insulating substrate to which the metal foil is not bonded and the ground conductive layer.

Preferably, the deterioration preventing layer is constituted by at least one element selected from the group consisting of Ni, Cr, Co, Zn and Si or by one of an alloy, an oxide and a nitride containing the at least one element.

A product according to the present invention may include the conductive sheet, and preferably the product is one of an electric product, an electronic product, a semiconductor product, an antenna circuit board, an IC card, a solar battery, and an automobile.

The conductive sheet according to the present invention shows drastically improved adhesion between the insulating substrate and the ground conductive layer, since the ground conductive layer is formed by the sputtering method or the vapor deposition method to all of the surface (when the metal foil is bonded, to the surface to which the metal foil is not bonded) of the insulating substrate including the wall surface of the via hole, as described above. Additionally, the top conductive layer has excellent adhesion with the ground conductive layer. Through their synergistic action, the conductive sheet in which a so-called conductive layer made of the ground conductive layer and the top conductive layer is formed on the insulating substrate with high adhesion is provided.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a schematic cross-sectional view of a conductive sheet according to the present invention.
Fig. 2 is a schematic plan view of the conductive sheet according to the present invention.
Fig. 3A is one of illustrations showing the flow of manufacturing steps of the conductive sheet according to the present invention, and it is a schematic cross-sectional view of an insulating substrate.
Fig. 3B is one of the illustrations, and it is a schematic cross-sectional view of the insulating substrate in a state where alignment holes and via holes are formed.
Fig. 3C is one of the illustrations, and it is a schematic cross-sectional view of the insulating substrate in a state where a deterioration preventing layer and a ground conductive layer are formed.
Fig. 3D is one of the illustrations, and it is a schematic cross-sectional view of the conductive sheet completed by formation of a top conductive layer.
Fig. 4A is one of illustrations showing the flow of another manufacturing steps of the conductive sheet according to the present invention, and it is a schematic cross-sectional view of an insulating substrate.
Fig. 4B is one of the illustrations, and it is a schematic cross-sectional view of the insulating substrate in a state where alignment holes and via holes are formed.
Fig. 4C is one of the illustrations, and it is a schematic cross-sectional view of the insulating substrate in a state where a deterioration preventing layer and a ground conductive layer are formed.
Fig. 4D is one of the illustrations, and it is a schematic cross-sectional view of the insulating substrate in a state where a resist is formed on the ground conductive layer.
Fig. 4E is one of the illustrations, and it is a schematic cross-sectional view of the insulating substrate in a state where a top conductive layer is formed on a portion to which the resist is not formed.
Fig. 4F is one of the illustrations, and it is a schematic cross-sectional view of the insulating substrate in a state where the resist is stripped.
Fig. 4G is one of the illustrations, and it is a schematic cross-sectional view of the conductive sheet completed by stripping the deterioration preventing layer and the ground conductive layer by soft etching.
Fig. 5 is a schematic cross-sectional view of the conductive sheet according to the present invention using an insulating substrate to which a metal foil is bonded.

### DESCRIPTION OF THE PREFERRED EMBODIMENTS

In the following, embodiments of the present invention will be described referring to the figures. In the figures of the present specification, an identical reference character indicates the identical part or a corresponding part.

### Conductive Sheet and Its Application

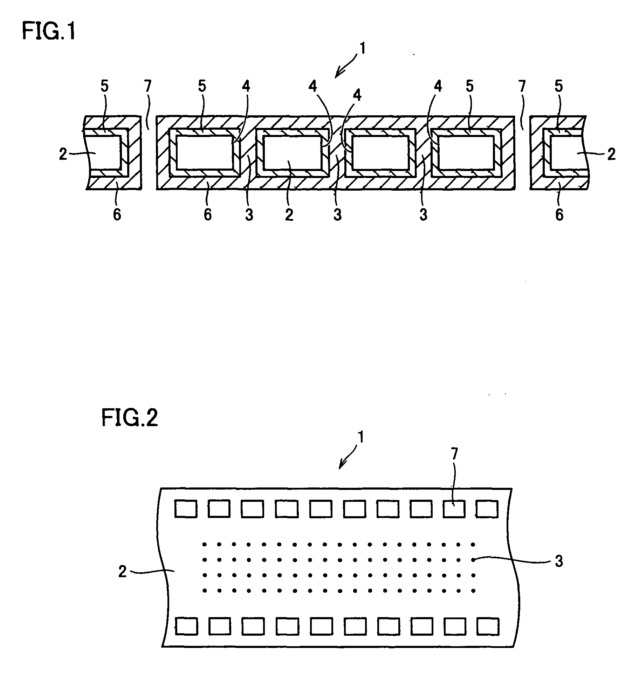

As shown in Fig. 1, a conductive sheet 1 according to the present invention includes an insulating substrate 2 having at least one via hole 3, in which a ground conductive layer 5 and a top conductive layer 6 are formed on all of a surface of the insulating substrate including a wall surface 4 of via hole 3.

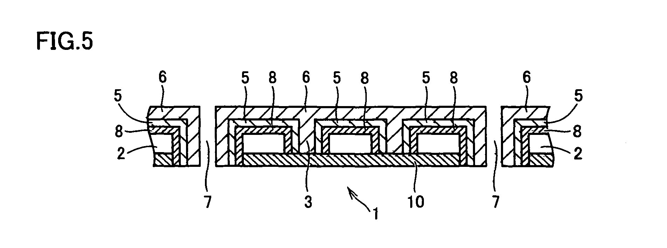

As the conductive sheet of the present invention, a sheet in which insulating substrate 2 and a metal foil 10 are bonded to each other can be used, as shown in Fig. 5.

Fig. 2 is a plan view of conductive sheet 1 of the present invention. It should be noted that an alignment mark 7 may be formed in conductive sheet 1 of the present invention.

The conductive sheet of the present invention having such a structure can be used as various circuit boards, by processing the ground conductive layer or the top conductive layer so as to form circuitry. Further, the metal foil can also be processed so as to form circuitry. Accordingly, the conductive sheet of the present invention can suitably be used for a circuit board for a semiconductor, a circuit board for electric/electronic component, various packaging, an automobile component, a solar battery, an antenna circuit board, an IC card and the like. The present invention also relates to various electric products, electronic products, semiconductor products, antenna circuit boards, IC cards, solar batteries or automobiles using such a conductive sheet. In the following, each constituent of the conductive sheet of the present invention will be described.

### Insulating Substrate

As the insulating substrate used as a base material of the conductive sheet of the present invention, anything can be used without specific limitation so long as it is a conventionally known object that can be used for such an application. Specifically, an object that is thin and film-shaped is suitable, since it is suited for formation of a ground conductive layer and the like, which will be described later. Also, it can be processed as a long continuous object such as a roll, thereby improving production efficiency.

Examples of such an insulating substrate include films of polyester such as PET, PEN and the like, polyimide, aramid, polysulfone, polyetherimide, polyphenylene oxide, liquid crystal polymer, glass fiber reinforced epoxy resin, phenol resin, acrylic resin and the like. Preferably, among these films, the films formed of polyester such as PET, PEN and the like, polyimide, and glass fiber reinforced epoxy resin should be used, as they are particularly excellent in flexibility and capable of attaining high performance.

An insulating substrate having a thickness of 4-300µm, preferably of about 12-50µm is suitable. With a thickness less than 4µm, the strength may become weak and formation of the ground conductive layer and the like may become difficult. On the other hand, with a thickness more than 300µm, formation of the ground conductive layer and the like to the via hole, which will be described later, may be hindered, and formation into a shape of a roll becomes difficult when the insulating substrate is a long object.

While the insulating substrate is particularly suitable when it is film-shaped as described above, it may take a shape in a manner of separate pieces or in a manner of a long continuous object such as a roll so long as it is film-shaped. In the present invention, particularly from the viewpoint of the process efficiency in manufacturing the conductive sheet, it is suitable to employ a long continuous object such as a roll.

### Insulating Substrate to Which Metal Foil is Bonded

As the insulating substrate of the present invention, an insulating substrate to one surface of which a metal foil is bonded may be used. In this case, a via hole, which will be described later, will be formed so as to penetrate only through the insulating substrate and to leave the metal foil. It should be noted that, such a via hole can be formed either before or after bonding the insulating substrate and the metal foil.

The metal foil and the insulating substrate of the present invention can be bonded to each other with an adhesive or the like. Additionally, the metal foil may be provided with resin by casting so that the resin forms the insulating substrate. Thus, the metal foil and the insulating substrate may be formed by any formation method.

As such a metal foil, a metal foil having a thickness of 2-200µm, preferably of 12-35µm can be used. With a thickness less than 2µm, the process of bonding to the insulating substrate and the like may become difficult. On the other hand, with a thickness more than 200µm, formation of circuitry by etching or the like becomes difficult.

As such a metal foil, it is particularly preferable to use a copper foil, since it is excellent in conductivity and suitable for forming circuitry.

It should be noted that, such a metal foil can be formed as a desired circuitry pattern, by being processed to form circuitry similarly to the ground conductive layer or the top conductive layer, which will be described later. Specifically, when forming circuitry that is not finely shaped to a high degree on one surface of the conductive sheet, it is preferable to form such circuitry with this metal foil.

### Preprocess of Insulating Substrate by Ion Gun

As the insulating substrate used in the present invention, it is preferable to use an insulating substrate irradiated with at least one type of ions using an ion gun by which a target object is irradiated with ions. Examples of such ions include rare gas ions such as argon, oxygen ions, nitrogen ions, and the mixture of these ions.

When the insulating substrate is irradiated with ions, extremely improved adhesion of the ground conductive layer or the deterioration preventing layer, which will be described layer, to the insulating substrate is attained. Though the mechanism of such a phenomenon has not been clarified in detail yet, it is considered that the ion irradiation causes activation of the surface of the insulating substrate or it causes roughening treatment (unevenness providing treatment) in an extremely fine manner.

It is preferable that such an ion irradiation to the insulating substrate is performed after the via hole, which will be described later, is formed. Additionally, when the metal foil is bonded thereto as described above, the ion irradiation can be performed either before or after the insulating substrate and the metal foil are bonded to each other.

As for the condition of ion irradiation by an ion gun, for example, with an apparatus having the ion gun, the irradiation can be performed under the condition of vacuum of 1×10⁻³ - 7×10⁻¹ Pa, preferably 5×10⁻³ - 5×10⁻¹ Pa, ion raw material gas 50 - 500cc/min, preferably 180 - 250cc/min, target current 0.01 - 5kW/dm², preferably 0.1 - 3kW/dm².

### Via Hole

The insulating substrate of the present invention has at least one via hole. Such a via hole is a fine pore penetrating through the insulating substrate. In the conductive sheet of the present invention, the via hole is filled with the top conductive layer, which will be described later, whereby the top conductive layers formed on both front and back surfaces of the insulating substrate (when the metal foil is bonded, the metal foil and the top conductive layer) are electrically connected.

The shape of such a via hole is not specifically limited so long as the via hole penetrates through the front and back surfaces of the insulating substrate, and for example, the cross section of the via hole may be circular or polygonal. Suitably, the via hole has an inner diameter of 5-200µm, preferably 10-50µm. With an inner diameter less than 5µm, forming the hole becomes difficult and the processing costs are increased. On the other hand, with an inner diameter more than 200µm, a long time will be required for the hole to be filled with the top conductive layer, which will be described later, whereby the production efficiency is reduced. It should be noted that, the inner diameter of such a via hole is advantageous in designing circuitry if it is formed smaller, in a range not increasing the processing cost.

Preferably, such a via hole is open by substantially the same area in both front and back surfaces of the insulating substrate, but it may be open by different areas.

Such a via hole can be formed by any method without specific limitation so long as it is a conventionally known hole-forming method (a boring process method). For example, it may be formed to penetrate through the insulating substrate by a method using various lasers such as a CO₂ laser, a YAG laser, and an excimer laser, or by a method using pressing or punching. It should be noted that, as a hole-forming apparatus employing such a method, it is particularly preferable to use an apparatus that continuously processes the insulating substrate and thereafter reels it up, since it may contribute to the improvement of the production efficiency.

### Ground Conductive Layer

The ground conductive layer of the present invention is formed by the sputtering method or the vapor deposition method on all of a surface of the insulating substrate (when a metal foil is bonded, the surface to which the metal foil is not bonded) including a wall surface of the via hole. Such a ground conductive layer primarily has action of assisting the top conductive layer, which will be described later, to be carried on the insulating substrate with high adhesion, and action of applying conductivity to the conductive sheet cooperating with the top conductive layer.

As for the processing condition of the sputtering method or the vapor deposition method, any conventionally known condition can be selected as appropriate, so as to conform to the type of elements being used and the thickness of the ground conductive layer being formed.

For example, as for the processing condition of the sputtering method, in a sputtering apparatus, the process can be performed under the condition of vacuum of 1×10⁻³ - 7×10⁻¹ Pa, preferably 5×10⁻³ - 5×10⁻¹ Pa, argon gas 50 - 500cc/min, preferably 180 - 250cc/min, target current 0.01 - 5kW/dm², preferably 0.1 - 3kW/dm². As for the processing condition of the vapor deposition method, in a vapor deposition apparatus, the process can be performed under the condition of vacuum of 1×10⁻⁵ - 1×10⁻³ Pa, preferably 1×10⁻⁴ - 1×10⁻³ Pa, output 5 - 100kW, preferably 1 - 30kW.

As described above, by forming the ground conductive layer by the sputtering method or the vapor deposition method, the elements constituting the ground conductive layer are formed extremely densely and evenly to the surface of the insulating substrate (including the wall surface of the via hole). Thus, high adhesion between the insulating substrate and the ground conductive layer is attained. Such high adhesion is an excellent effect that cannot be obtained when the ground conductive layer is formed by the electroless plating method. It should be noted that, as described above, having the insulating substrate irradiated with ions using an ion gun, the particularly preferable state thereof can be attained since the irradiation synergistically acts with the adhesion improving effect of the ground conductive layer, whereby further higher adhesion can be attained.

Preferably, such a ground conductive layer may be constituted by at least one metal selected from the group consisting of Cu, Ag, Sn, Ni, Bi and Zn, or by an alloy containing the at least one metal. More preferably, such a ground conductive layer may be constituted by Cu or an alloy containing Cu.

It is suitable to form such a ground conductive layer in a thickness of 500 - 5000Å, preferably 1000 - 3000Å. With a thickness less than 500Å, the action of improving the adhesion of the top conductive layer, which will be described later, will not fully be attained. On the other hand, a thickness more than 5000Å does not largely contribute to adhesion of the top conductive layer while it is not cost-effective.

Such a ground conductive layer may be formed as one layer (a single layer) or as at least two layers (a plurality of layers) being stacked. When at least two layers are stacked, the total thickness of them may be the thickness as described above.

It should be noted that, as the various apparatuses for forming the ground conductive layer by the sputtering method or the vapor deposition method, it is preferable to use an apparatus that continuously processes the insulating substrate and thereafter reels it up, and particularly, it is preferable to use an apparatus with an ion gun. Thus, it may contribute to the improvement of the production efficiency, and the insulating substrate may be prevented from becoming inert again after each process.

### Top Conductive Layer

The top conductive layer of the present invention is formed on all of or part of the surface of the ground conductive layer, and the via hole is filled with this top conductive layer. Specifically, such a top conductive layer primarily forms an interconnection layer, and has action of applying conductivity to the conductive sheet.

Accordingly, it is preferable to form such a top conductive layer greater in thickness than the ground conductive layer. Thus, excellent electric properties such as reduced electric resistance can be obtained.

Preferably, such a top conductive layer may be formed by the electroplating method, by which the via hole is filled concurrently. It is suitable because the production efficiency is improved, while the top conductive layer is integrally formed within the via hole, applying conductivity with high reliability to the conductive sheet.

As for the condition of the electroplating method, any conventionally known condition can be selected as appropriate, so as to conform to the type of elements constituting the top conductive layer and the thickness of the top conductive layer being formed. For example, using a plating solution (containing metal in an appropriate concentration, e.g., as for copper, copper sulfate 50 - 200g/l, sulfuric acid 100 - 250g/l, chloride 10 - 100ppm), the process can be performed under the condition of solution temperature 10 - 90°C, preferably 15 - 60°C, current density 0.1 - 10A/dm², preferably 0.5 - 5A/dm². Particularly, it is preferable to select one of DC, pulse, PR and chopper as a waveform of the output side when performing electroplating.

As described above, by forming the top conductive layer by the electroplating method, extremely high adhesion with the ground conductive layer can be attained, and the thickness thereof can further be increased. Additionally, the via hole can be filled concurrently with the formation of the top conductive layer.

Preferably, such a top conductive layer may be constituted by at least one metal selected from the group consisting of Cu, Ag, Sn, Ni, Bi and Zn, or by an alloy containing the at least one metal. More preferably, such a top conductive layer may be constituted by Cu or an alloy containing Cu. Further, preferably, the top conductive layer is formed by the identical material with the ground conductive layer. Thus, it will attain further higher adhesion with the ground conductive layer.

It is suitable to form such a top conductive layer in a thickness of 0.5 - 50µm, preferably 5 - 20µm. With a thickness less than 0.5µm, sufficient electric conductivity cannot be attained while electric resistance becomes excessively great. On the other hand, a thickness more than 50µm does not largely contribute to electric conductivity while it is not cost-effective.

Such a top conductive layer may be formed as one layer (a single layer) or as at least two layers (a plurality of layers) being stacked. When at least two layers are stacked, the total thickness of them may be the thickness as described above.

It should be noted that, as the various apparatuses forming the top conductive layer by the electroplating method, it is preferable to use an apparatus that continuously processes the insulating substrate and thereafter reels it up, since it may contribute to the improvement of the production efficiency.

### Deterioration Preventing Layer

According to the present invention, between all of the surface of the insulating substrate (when a metal foil is bonded, the surface to which the metal foil is not bonded) including the wall surface of the via hole and the ground conductive layer, the deterioration preventing layer can be formed by the sputtering method or the vapor deposition method. Such a deterioration preventing layer has action of effectively preventing the ground conductive layer from deteriorating, e.g., by oxidation due to oxygen or moisture in the air as time elapses. If the ground conductive layer deteriorates, adhesion with the insulating substrate is impaired. Hence, as a result, such a deterioration preventing layer contributes to improvement of adhesion between the insulating substrate and the ground conductive layer.

As for the processing condition of the sputtering method or the vapor deposition method, similarly to the case of the ground conductive layer, any conventionally known condition can be selected as appropriate, so as to conform to the type of elements being used and the thickness of the deterioration preventing layer being formed.

For example, as for the processing condition of the sputtering method, in a sputtering apparatus, the process can be performed under the condition of vacuum of 1×10⁻³ - 7×10⁻¹ Pa, preferably 5×10⁻³ - 5×10⁻¹ Pa, argon gas 50 - 500cc/min, preferably 180 - 250cc/min, target current 0.01 - 5kW/dm², preferably 0.1 - 3kW/dm². As for the processing condition of the vapor deposition method, in a vapor deposition apparatus, the process can be performed under the condition of vacuum of 1×10⁻⁵ - 1×10⁻³ Pa, preferably 1×10⁻⁴ - 1×10⁻³ Pa, output 5 - 100kW, preferably 1 - 30kW.

As described above, by forming the deterioration preventing layer by the sputtering method or the vapor deposition method, the elements constituting the deterioration preventing layer are formed extremely densely and evenly to the surface of the insulating substrate (including the wall surface of the via hole). Thus, high adhesion between the insulating substrate and the deterioration preventing layer itself is attained. Such high adhesion is an excellent effect that cannot be obtained when the deterioration preventing layer is formed by the electroless plating method. It should be noted that, as described above, having the insulating substrate irradiated with ions using an ion gun, the particularly preferable state thereof can be attained since these actions synergistically serve, whereby further higher adhesion between the insulating substrate and the ground conductive layer can be attained.

Preferably, such a deterioration preventing layer may be constituted by at least one element selected from the group consisting of Ni, Cr, Co, Zn, and Si, or by an alloy, an oxide or a nitride containing the at least one element. By forming the deterioration preventing layer with such a material, the ground conductive layer can extremely effectively be prevented from deteriorating.

It is suitable to form such a deterioration preventing layer in a thickness of 20 - 200Å, preferably 40 - 60Å. With a thickness less than 20Å, it may not prevent deterioration of the ground conductive layer effectively. On the other hand, a thickness more than 200Å may result in difficulties in etching when circuitry is formed, which will be described later, and may cause short-circuiting of the circuitry.

Such a deterioration preventing layer may be formed as one layer (a single layer) or as at least two layers (a plurality of layers) being stacked. When at least two layers are stacked, the total thickness of them may be the thickness as described above.

It should be noted that, as various apparatuses for forming the deterioration preventing layer by the sputtering method or the vapor deposition method, it is preferable to use the similar apparatus as used for forming the ground conductive layer. Specifically, it is preferable to use an apparatus that continuously processes the insulating substrate and thereafter reels it up, and particularly, it is preferable to use the apparatus with an ion gun. Using such an apparatus, the ground conductive layer and the deterioration preventing layer can continuously be formed by adjusting the type of element set to the target or the number of sets. Thus, it may contribute to the improvement of the production efficiency as well as prevent the insulating substrate from becoming inert again after each process.

### Formation of Circuitry and Others

The ground conductive layer or the top conductive layer of the present invention can be processed so as to form circuitry. Needless to say, both the ground conductive layer and the top conductive layer can be processed so as to form circuitry.

For example, forming the top conductive layer on all of the surface of the ground conductive layer as described above, and thereafter etching the ground conductive layer and the top conductive layer together so as to form a desired circuitry pattern, circuitry can be formed.

Forming the ground conductive layer, and thereafter partially masking the top of the ground conductive layer with resist, the top conductive layer is formed to a portion that is not masked. Thereafter, by performing soft-etching to the resist and the ground conductive layer, a circuitry pattern can be formed.

It should be noted that, when the deterioration preventing layer is formed, etching or soft-etching is performed to the deterioration preventing layer together with the ground conductive layer.

### Others

To the insulating substrate of the present invention, an alignment mark can be formed. The alignment mark serves as a reference for determining a prescribed position of a via hole. Usually, it is suitable to form the alignment mark at each of opposite ends (where a via hole is not formed) of the insulating substrate.

Such an alignment mark may be anything so long as a prescribed position of a via hole can be determined by an optical, an electronic, a magnetic, a visual or any other reading means. The forming method thereof is also not specifically limited. For example, when visually read, a suitable alignment mark is a hole formed so as to penetrate through opposite ends of the insulating substrate. More preferably, this hole (referred to as an alignment hole) is suitable to be formed successively at constant intervals, since such a configuration allows the position of the via hole to be determined further easily.

Preferably, the size of such an alignment hole is about 10µm-3mm normally, and more preferably, 25µm-1mm. With a size less than 10µm, processing may become difficult and production costs are increased. On the other hand, with a size more than 3mm, accuracy in determining the position of the via hole may be deteriorated.

Such an alignment hole can be formed by various lasers, drills, punching, pressing and the like. It is preferable to use various lasers when such an alignment hole is less than 80µm. It should be noted that, as a hole-forming apparatus employing such a method, it is particularly preferable to use an apparatus that continuously processes the insulating substrate and thereafter reels it up, since it may contribute to the improvement of the production efficiency.

Similarly to the via hole, to the wall surface of such an alignment hole, the ground conductive layer can be formed. The deterioration preventing layer can also be formed thereto when deterioration preventing layer is formed.

When such an alignment hole has a size that is the same or smaller than that of the via hole, it may be filled with the top conductive layer in the same manner as the via hole. When the alignment hole is larger than the via hole, the hole is not necessarily filled completely with the top conductive layer.

A combining layer for an integrated circuit or an oxidation preventing layer can be formed on the top conductive layer. The combining layer for an integrated circuit has action of facilitating mounting an integrated circuit (an IC chip or an LSI) on the insulating substrate, and it electrically connects the top conductive layer and the integrated circuit directly. The oxidation preventing layer has action of preventing the top conductive layer from being oxidized and losing conductivity, or from losing excellent adhesion with the insulating substrate.

Preferably, such a layer may be constituted by at least one metal selected from the group consisting of Sn, Ni, Au, Ag, Zn, and Cr, or by an alloy containing the at least one metal.

As for the thickness, in the case of the combining layer for an integrated circuit, it is suitable to form in a thickness of 0.2-15µm, preferably 0.5-5µm. With a thickness less than 0.2µm, the effect of facilitating mounting the integrated circuit is not attained. On the other hand, a thickness more than 15µm does not largely contribute to the effect of facilitating mounting the integrated circuit while it is not cost-effective, and therefore it is not preferable.

In the case of the oxidation preventing layer, it is suitable to form in a thickness of 0.01-2µm, preferably 0.05-1µm. With a thickness less than 0.01µm, the action described above is not attained. On the other hand, a thickness more than 2µm does not largely contribute to the action while it is not cost-effective, and therefore it is not preferable.

Such a layer can be formed on all of the surface of the conductive layer, or on part thereof like a bump, as a single layer or a plurality of layers, by one of the electroless plating method, the electroplating method, and the chromating method.

### Product

The product according to the present invention includes the conductive sheet described above. Such a product may include an electric product, an electronic product, a semiconductor product, an antenna circuit board, an IC card, a solar battery, an automobile and the like.

### Examples

In the following, while the present invention will be described in detail showing examples, the present invention is not limited thereto.

### Example 1

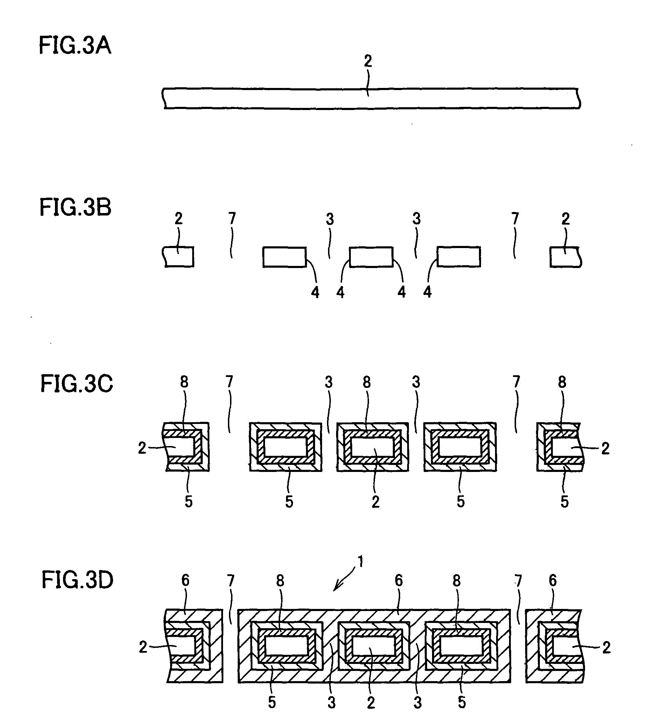

Referring to Figs. 3A-3C, the manufacturing steps of conductive sheet 1 of the present invention will be described.

First, as insulating substrate 2 (Fig. 3A), a polyimide film (product name: Kapton EN, available from DuPont) cut to have a thickness of 25µm, a width of 250mm and a length of 100m was reeled up around a core made of aluminum and set on a CO₂ laser processing machine (available from Mitsubishi Electric Corporation). In advance, data of size and position of an alignment hole as alignment mark 7 and via hole 3, and laser shot number had been input to the processing machine. Based on the data, via holes 3 each having an inner diameter of 45µm and alignment holes each having an inner diameter of 100µm were successively formed so as to penetrate through both front and back surfaces of the polyimide film (Fig. 3B).

Subsequently, to insulating substrate 2 to which hole-forming process was performed by the CO₂ laser as described above, the following process was performed in order to remove dirt and carbide resulted from the hole-forming process at and around the hole-formed portion. Specifically, insulating substrate 2 was set on a desmear apparatus, and immersed in an immersion bath of potassium permanganate aqueous solution of 50g/l having a solution temperature of 70°C for 60 seconds. Thereafter, cleaning with pure water was repeated for five times.

Thereafter, it was further immersed in an immersion bath of sulfuric acid of 10% and having a solution temperature of 40°C for 150 seconds for neutralization. Thereafter, cleaning with pure water was again repeated for five times. Subsequently, it was drained by the drying air of 105°C passed through a high performance filter (a filter with pores each in a size at most 0.5µm) so as to be fully dried. Thus, dirt and carbide resulted from the aforementioned process were removed. Thereafter, insulating substrate 2 subjected to such processes were again reeled up around the core made of aluminum, and taken out of the desmear apparatus.

Next, one end of insulating substrate 2 reeled up around the core made of aluminum was set on a feeding-out shaft of a sputtering apparatus, and the other end was set on a reeling-up shaft. As the sputtering apparatus is provided with an ion gun, insulating substrate 2 was first irradiated with ions by the ion gun, and thereafter the deterioration preventing layer 8 and ground conductive layer 5 were successively stacked.

Here, as the process by the ion gun, the process was performed with argon ions under condition of argon gas 100cc/min, power supply 0.5kW/dm², and the degree of vacuum of 2×10⁻¹ Pa.

In the sputtering following the aforementioned process, deterioration preventing layer 8 and ground conductive layer 5 were formed under the following condition to all of the surface of insulating substrate 2 and the wall surfaces of via hole 3 and the alignment hole subjected to ion irradiation.

Specifically, to five targets of the sputtering apparatus, an alloy of Ni:Cr = 80:20 was mounted as a target No. 1, and Cu was mounted as each of targets Nos. 2-5. First, under the condition of argon gas injection amount of 200 cc/min, target current 0.5kW/dm², and degree of vacuum 2×10⁻¹ Pa to the target No. 1 to which Ni:Cr alloy was mounted, and under the condition of argon gas injection amount of 250 cc/min, target current 1.2kW/dm², degree of vacuum 2×10⁻¹ Pa to each of the targets Nos. 2-5 to which Cu was mounted, these metals were sputtered. Thus, deterioration preventing layer 8 made ofNi:Cr alloy was formed on one surface of the insulating substrate, and ground conductive layer 5 made of Cu was formed on that deterioration preventing layer 8. Thereafter, the vacuum of the sputtering apparatus was removed.

Subsequently, the insulating substrate was turned over and set on the sputtering apparatus again so that the same process as described above could be performed to the surface of insulating substrate 2 to which deterioration preventing layer 8 and ground conductive layer 5 were not formed. Then, after performing ion irradiation under the identical condition as described above and thereafter performing sputtering, deterioration preventing layer 8 and ground conductive layer 5 which were the same as described above were formed on the other surface of the insulating substrate (Fig. 3C).

Thus, to both the front and back surfaces of insulating substrate 2 and the wall surfaces of the via hole and the alignment hole, deterioration preventing layer 8 made of Ni:Cr alloy was formed first, and then the ground conductive layer made of Cu was formed thereon. This structure is identical at both the front and back surfaces of the insulating substrate and at wall surfaces of the via hole and the alignment hole. It should be noted that, while the process was performed twice each for the front and back surfaces of the insulating substrate in the present embodiment because of the structure of the apparatus, it is not necessary to perform the process twice if an apparatus that can process both the front and back surfaces at once is employed.

Here, insulating substrate 2 was sampled at the points away from one end by 10m, 50m and 90m, where an FIB (Focused Ion Beam) apparatus was used to cut and to measure the thickness at the cross sections. At each of the points, averaging the values of both the front and back surfaces of the insulating substrate and the wall surfaces of each holes, the thickness of the deterioration preventing layer was 60Å, and the thickness of the ground conductive layer was 2500Å.

Subsequently, after performing cleaning with pure water for several times, insulating substrate 2 to which the deterioration preventing layer and the ground conductive layer were formed as described above to each of the front and back surfaces was set on a continuous plating apparatus, and electroplating was performed under the following condition. Specifically, by continuously immersing the insulating substrate in an acid activation bath that was filled with sulfuric acid of 7% at a solution temperature of 30°C for 60 seconds, the activation process by acid was performed to the ground conductive layer.

Next, after repeating cleaning with pure water for three times, the insulating substrate was continuously immersed at a moving rate of 1.0m/min in a plating bath of the aforementioned apparatus filled with a plating solution (made of copper sulfate 100g/l, sulfuric acid 150g/l, chloride 60ppm and TOP LUCINA 380H (available from Okuno Chemical Industries, Co., Ltd.) 10cc/l), and performing electroplating under condition of solution temperature 30°C and current density 4A/dm² for 11 minutes, top conductive layer 6 made of Cu was formed on ground conductive layer 5, and via hole 3 was filled with this top conductive layer 6 concurrently.

Subsequently, cleaning of insulating substrate 2 to which top conductive layer 6 was formed was repeatedly performed with pure water for five times. Next, it was drained by the drying air of 105°C passed through a high performance filter (a filter with pores each in a size at most 0.5µm) so as to be fully dried. Thus, conductive sheet 1 of the present invention was obtained, in which top conductive layer 6 was formed on each of the front and back surfaces of insulating substrate 2 and in the via hole (Fig. 3D).

Here, conductive sheet 1 was sampled at the points away from one end by 10m, 50m and 90m, where the FIB apparatus was used to cut and to measure the thickness of top conductive layer 6. At each of the points, for each of the front and back surfaces of the insulating substrate, the averaged thickness was 9.8µm, and the via hole was fully filled.

### Example 2

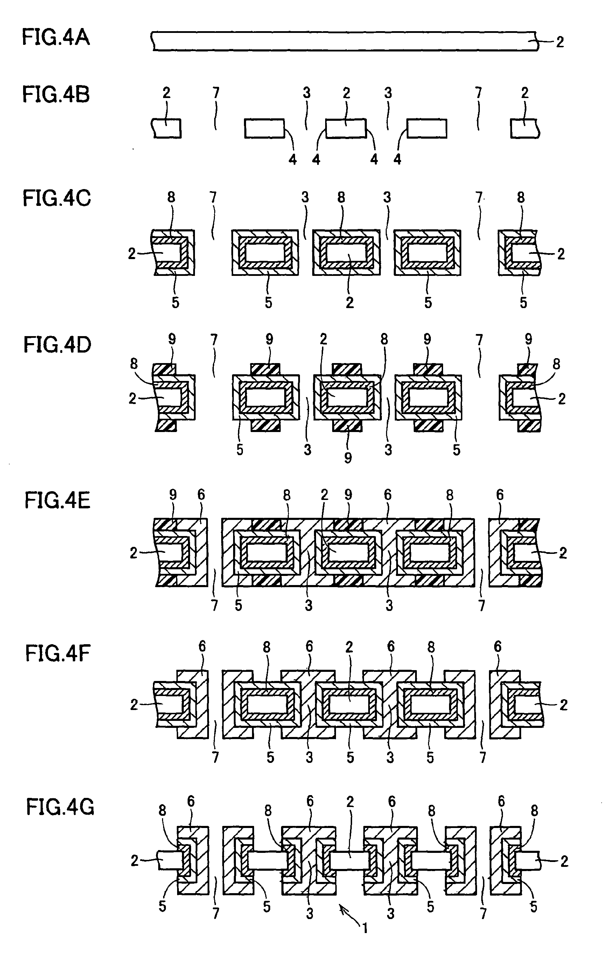

As to manufacturing steps of conductive sheet 1 according to the present invention, circuitry formation steps will mainly be described referring to Figs. 4A-4G.

First, following the same processes as in Example 1 to the stage where deterioration preventing layer 8 and ground conductive layer 5 were formed, insulating substrate 2 to which deterioration preventing layer 8 and ground conductive layer 5 were formed was obtained (Figs. 4A-4C).

Next, on ground conductive layer 5, a pattern mask was provided by laminating an UV cure resist so as to form a desired circuitry pattern. Thereafter, exposing and developing processes were performed (Fig. 4D).

Next, to the portion on ground conductive layer 5 thus processed where the resist had not been formed, top conductive layer 6 made of Cu was formed by performing electroplating under the same condition as Example 1 (Fig. 4E).

Subsequently, the resist was stripped from the portion where top conductive layer 6 had not been formed (Fig. 4F). Thereafter, from the portion where the resist had been stripped, the ground conductive layer and the deterioration preventing layer were stripped by soft etching. Thus, conductive sheet 1 of the present invention in which circuitry was formed by the top conductive layer and the like was obtained (Fig. 4G).

Here, the conductive sheet was sampled at the points away from one end by 10m, 50m and 90m, where the FIB apparatus was used to cut and to measure the thickness of top conductive layer 6. At each of the points, for each of the front and back surfaces of the insulating substrate, the averaged thickness was 10.1µm, and the via hole was fully filled.

### Example 3

The present example is manufacture of a conductive sheet using an insulating substrate to which a metal foil is bonded.

First, the same insulating substrate as in Example 1 was employed as insulating substrate 2, and a copper foil having a thickness of 18µm was bonded as metal foil 10 to one of the surfaces of insulating substrate 2.

Next, similarly as Example 1, via hole 3 was formed so as to penetrate only through insulating substrate 2 and leaving the copper foil, and an alignment hole was formed so as to penetrate through both the copper foil and insulating substrate 2. Thereafter, similarly as Example 1, dirt and carbide resulted at and around the hole-formed portion were removed.

Subsequently, after the surface of insulating substrate 2 to which a copper foil was not bonded (including the wall surfaces of the via hole and the alignment hole) was irradiated with ions by an ion gun as in Example 1, deterioration preventing layer 8 and ground conductive layer 5 were formed. Specifically, while the same process was performed twice each for the front and back surfaces of insulating substrate 2 in Example 1, it was performed only once in the present example.

Then, similarly as Example 1, top conductive layer 6 was formed on this ground conductive layer 5, and thus conductive sheet 1 of the present invention shown in Fig. 5 was obtained.

Conductive sheet 1 thus obtained can be processed so that top conductive layer 6 (including deterioration preventing layer 8 and ground conductive layer 5) and metal foil 10 form any circuitry pattern.

### Adhesion Test

The adhesion strength between the insulating substrate and the top conductive layer in the conductive sheet according to each of Examples 1-3 was measured using a peel test apparatus (MODEL 1305N, available from AIKOH ENGINEERING CO., LTD.). Specifically, the conductive sheet obtained by each of examples was cut by 1 cm width, of which insulating substrate side was fixed by a double faced tape and the edge of top conductive layer was peeled off by a small amount. To this portion, the hook of the test apparatus was attached. By pulling the hook, the adhesion strength between the insulating substrate and the top conductive layer was measured.

This measurement was conducted for each condition, i.e., immediately after the conductive sheet was manufactured (this condition is referred to as Condition I), when heated at 200°C for 1 hour (this condition is referred to as Condition II), and when maintained at 60°C and the humidity of 90% for 168 hours (this condition is referred to as Condition III).

For the purpose of comparison, the adhesion strength between the insulating substrate and the top conductive layer was measured under the same conditions as above, also for each of the following: A conductive sheet that was made according to Example 1 without the ion irradiation process by an ion gun (indicated as Comparative Example A); a conductive sheet that was made according to Example 1 without forming a deterioration preventing layer (indicated as Comparative Example B); a conductive sheet that was made according to Example 1 without the ion irradiation process by an ion gun and without forming a deterioration preventing layer (indicated as Comparative Example C); and a conductive sheet that was made according to Example 1 without the ion irradiation process by an ion gun and without forming a deterioration preventing layer and in which ground conductive layer was formed by an electroless plating method (using a commercially available electroless copper plating solution and following a common procedure) in place of the sputtering method (Comparative Example 1). The result is shown in the following Table 1.

**Table 1**

| | Condition I | Condition II | Condition III |
|---|---|---|---|
| Example 1 | 1.40kg/cm | 1.38kg/cm | 1.39kg/cm |
| Example 2 | 1.42kg/cm | 1.35kg/cm | 1.38kg/cm |
| Example 3 | 1.51kg/cm | 1.45kg/cm | 1.47kg/cm |
| Comparative Example A | 0.91kg/cm | 0.82kg/cm | 0.81kg/cm |
| Comparative Example B | 1.48kg/cm | 0.7kg/cm | 0.58kg/cm |
| Comparative Example C | 0.89kg/cm | 0.28kg/cm | 0.18kg/cm |
| Comparative Example 1 | 0.21kg/cm | 0.15kg/cm | 0.16kg/cm |

As can be seen from Table 1, comparing Example 1 and Comparative Example A, it is recognized that the adhesion strength is increased by the ion irradiation by an ion gun. Further, comparing Example 1 and Comparative Example B, it is recognized that the adhesion strength is increased by formation of the deterioration preventing layer. Still further, comparing Example 1, Comparative Examples A-C and Comparative Example 1, it is recognized that the sufficient adhesion strength cannot be attained by a conductive sheet (Comparative Example 1) in which ground conductive layer is formed by the electroless plating method, and it is necessary to form the ground conductive layer by the sputtering method or the vapor deposition method, and that the ion irradiation, the formation of the deterioration preventing layer, and the formation of ground conductive layer by the sputtering method may synergistically act.

Although the present invention has been described and illustrated in detail, it is clearly understood that the same is by way of illustration and example only and is not to be taken by way of limitation, the spirit and scope of the present invention being limited only by the terms of the appended claims.

## Claims

1. A conductive sheet (1), comprising: an insulating substrate (2) having at least one via hole (3); a deterioration preventing layer (8); a ground conductive layer (5); and a top conductive layer (6), wherein
said insulating substrate (2) is irradiated with ions by an ion gun,
said via hole (3) is a fine pore penetrating through said insulating substrate (2),
said deterioration preventing layer (8) constituted by at least one element selected from the group consisting ofNi, Cr, Co, Zn and Si or by one of an alloy, an oxide and a nitride containing said at least one element is formed by a sputtering method or a vapor deposition method on all of a surface of said insulating substrate (2) including a wall surface of said via hole (3),
said ground conductive layer (5) is formed by the sputtering method or the vapor deposition method on all of a surface of said deterioration preventing layer (8),
said top conductive layer (6) is formed by an electroplating method on all of or part of a surface of said ground conductive layer (5), and
said via hole (3) is filled with said top conductive layer (6) concurrently with formation of said top conductive layer (6).

2. The conductive sheet (1) according to claim 1, wherein
said via hole (3) is open by substantially a same area in both front and back surfaces of said insulating substrate (2).

3. The conductive sheet (1) according to claim 1, wherein
said ground conductive layer (5) or said top conductive layer (6) is processed so as to form circuitry.

4. A product comprising the conductive sheet (1) according to claim 3.

5. The product according to claim 4, wherein
said product is one of an electric product, an electronic product, a semiconductor product, an antenna circuit board, an IC card, a solar battery, and an automobile.

6. The conductive sheet (1) according to claim 1, wherein
said ground conductive layer (5) and said top conductive layer (6) are constituted by Cu or an alloy containing Cu.

7. A conductive sheet (1), comprising: an insulating substrate (2) having at least one via hole (3); a metal foil (10); a deterioration preventing layer (8); a ground conductive layer (5); and a top conductive layer (6), wherein
said metal foil (10) is bonded to one surface of said insulating substrate (2),
said insulating substrate (2) is irradiated with ions by an ion gun,
said via hole (3) is a fine pore penetrating only through said insulating substrate (2),
said deterioration preventing layer (8) constituted by at least one element selected from the group consisting ofNi, Cr, Co, Zn and Si or by one of an alloy, an oxide and a nitride containing said at least one element is formed by a sputtering method or a vapor deposition method on a wall surface of said via hole (3) and on the other surface of said insulating substrate (2) without said metal foil (10) being bonded,
said ground conductive layer (5) is formed by the sputtering method or the vapor deposition method on all of a surface of said deterioration preventing layer (8),
said top conductive layer (6) is formed by an electroplating method on all of or part of a surface of said ground conductive layer (5), and
said via hole (3) is filled with said top conductive layer (6) concurrently with formation of said top conductive layer (6).

8. The conductive sheet (1) according to claim 7, wherein
said via hole (3) is open by substantially a same area in both front and back surfaces of said insulating substrate (2).

9. The conductive sheet (1) according to claim 7, wherein
said ground conductive layer (5) or said top conductive layer (6) is processed so as to form circuitry.

10. A product comprising the conductive sheet (1) according to claim 9.

11. The product according to claim 10, wherein
said product is one of an electric product, an electronic product, a semiconductor product, an antenna circuit board, an IC card, a solar battery, and an automobile.

12. The conductive sheet (1) according to claim 7, wherein
said metal foil (10) is processed so as to form circuitry.

13. A product comprising the conductive sheet (1) according to claim 12.

14. The product according to claim 13, wherein
said product is one of an electric product, an electronic product, a semiconductor product, an antenna circuit board, an IC card, a solar battery, and an automobile.

15. The conductive sheet (1) according to claim 7, wherein
said ground conductive layer (5) and said top conductive layer (6) are constituted by Cu or an alloy containing Cu.

16. The conductive sheet (1) according to claim 7, wherein
said metal foil (10) is a copper foil.
